# EUROPEAN PATENT SPECIFICATION

(11) **EP 2 030 208 B1**
(45) Date of publication and mention of the grant of the patent: **19.04.2017**
(21) Application number: 07735971.9
(22) Date of filing: 21.05.2007
(51) Int. Cl.: H01F 30/04, H03K 17/691, H01F 27/28

(54) **TRANSFORMER**
TRANSFORMATOR
TRANSFORMATEUR

(30) Priority: 01.06.2006 EP 06114808
(43) Date of publication of application: 04.03.2009
(73) Proprietor: Philips Lighting Holding B.V., 5656 AE Eindhoven (NL)
(72) Inventor: WAFFENSCHMIDT, Eberhard, 5656 AA Eindhoven (NL)
(74) Representative: Verweij, Petronella Daniëlle
(86) International application number: PCT/IB2007/051914
(87) International publication number: WO 2007/138525

(56) References cited:
- US-A1- 2002 167 783
- US-A1- 2005 110 606

## Description

The invention relates to a transformer having a primary winding and a plurality of secondary windings. The invention relates equally to an apparatus comprising such a transformer and to a method of producing such a transformer.

Some applications require a power supply with several similar, isolated power outputs. An example of such an application is a backlight module of a liquid crystal display (LCD) television (TV) set.

LCDs that are used for flat TV sets are passive displays. Therefore, they need a background illumination, which is provided by a backlight module. Such a backlight module usually comprises several fluorescent lamps. Each fluorescent lamp comprises two electrodes in the form of filaments, and each filament has two connections for a power supply. A typical backlight module comprises 8 fluorescent lamps with a total of 16 filaments and 32 connections.

An improved picture quality of an LCD can be achieved by dimming the backlight in dependence of the scene brightness, which leads to an enhanced dark scene contrast. An improved picture quality can further be achieved by scanning the fluorescent lamps sequentially, which leads to less motion artifacts. To enable such features, however, the filaments of the fluorescent lamps must be supplied with power independently of the lamp current. This can be achieved with a common power supply for all filaments. During the operation of the lamps, however, there will be a difference of the electrical potential between the filaments. Therefore, all filaments must be galvanically decoupled.

A power converter providing an output power to a backlight module thus needs a transformer with a separate secondary winding for each filament.

A conventional transformer providing a plurality of secondary winding outputs will be quite bulky. Especially the coil former will be large, because of the large number of required interconnections. Large components, however, are ill-suited for use number of required interconnections. Large components, however, are ill-suited for use in a flat TV set. The large size of the transformer may equally be a problem with various other applications requiring several isolated power outputs.

Furthermore, for some applications, the output power should be in a wide range independent of the load resistance. The resistance of the filaments of fluorescent lamps, for example, depends significantly on the temperature of the filaments. In addition, a fault detection for each individual output might be required for enabling a detection of a short circuit or an open output.

In a conventional transformer, all power outputs are magnetically coupled to the same magnetic flux. Therefore, the state of the power outputs cannot be detected individually for each output from the primary voltage or the primary current. A power matching and a fault detection can conventionally only be realized with a feedback for each individual power output. For example, an optocoupler device and a related matching circuit could be used for each individual secondary winding of a transformer. This is difficult to implement and involves high costs.

US 2005 / 0110606 discloses a printed circuit transformer.

It would be advantageous to provide an improved transformer for applications requiring a power supply with several power outputs. It would also be desirable to provide an apparatus comprising such an improved transformer.

To better address one or more of these concerns, in a first aspect of the invention, a transformer comprising a planar primary winding and a first plurality of planar secondary windings and a second plurality of planar secondary windings is presented. Each secondary winding provides an isolated output. The first plurality of planar secondary windings is arranged side by side in a plane parallel to the primary winding such that a portion of a magnetic flux generated by the planar primary winding penetrates each of the first plurality of planar secondary windings. The second plurality of planar secondary windings is arranged side by side in a plane parallel to the primary winding and to the first plurality of planar secondary windings such that a portion of a magnetic flux generated by the primary winding penetrates each of the second plurality of planar secondary windings. The second plurality of planar secondary windings is arranged such that it is shifted compared to the first plurality of planar secondary windings, such that the first and the second plurality of secondary windings are shifted against each other, such that the magnetic flux in the area between the secondary windings of the first layer can be used by the secondary windings in the second layer.

In a second aspect of the invention, an apparatus comprising the proposed transformer is presented.

Such an apparatus could be for instance a component of a larger apparatus, like a power converter. It could also be a final product, like a TV set.

In a third aspect of the invention, a method of producing a transformer is presented. The method comprises
- manufacturing a planar primary winding,
- manufacturing a first plurality of planar secondary windings and manufacturing a second plurality of planar secondary windings, wherein each secondary winding provides an isolated output, the first plurality of secondary windings being arranged side by side, and the second plurality of secondary windings being arranged side by side, and
- arranging the first plurality of planar secondary windings in a plane parallel to the primary winding such that a portion of a magnetic flux generated by the planar primary winding penetrates each of the first plurality of secondary windings and arranging the second plurality of secondary windings in a plane parallel to the primary winding and to the first plurality of planar secondary windings such that a portion of a magnetic flux generated by the primary winding penetrates each of the second plurality of secondary windings, and
- arranging the second plurality of planar secondary windings such that it is shifted compared to the first plurality of planar secondary windings, and such that the magnetic flux in the area between the secondary windings of the first layer can be used by the secondary windings in the second layer.

It is to be understood that the order of manufacturing the planar primary winding and the plurality of planar secondary windings is arbitrary. They could even be manufactured in a single processing step.

It is thus proposed that a transformer with a plurality of isolated outputs is constructed as a planar device and that the secondary windings that are used for providing these outputs are arranged side by side.

It is an advantage of the invention that the height of a transformer providing a plurality of power outputs can be reduced significantly. Consequently, also the size of any electronic circuit and of any apparatus comprising such a transformer can be reduced.

Such a layered construction allows accommodating a large number of secondary windings. The size of the transformer is not increased significantly by another layer of planar windings. The first plurality of planar secondary windings could be arranged for example between the planar primary windings and the second plurality of planar secondary windings, or the planar primary windings could be arranged between the first plurality of planar secondary windings and the second plurality of planar secondary windings.
By shifting the first and the second plurality of secondary windings against each other, the magnetic flux in the area between the secondary windings of a first layer can be used by the secondary windings in a second layer. As a result, a better overall coupling between primary winding and secondary windings is achieved than with two layers that are arranged exactly on top of each other. The better coupling leads to a better efficiency of the transformer. The space between the secondary windings can further be used in this case to route a track that connects the inner end of a secondary winding on the respective opposite layer to an outside connector.

In general, the windings of the transformers can be realized by any kind of technology, they could also be made, for instance, of copper wires.

In an exemplary embodiment, the primary winding and/or the plurality of secondary windings of the transformer are realized in a substrate, for example laminated in a printed circuit board (PCB). This substrate can also be flexible. Integrating the transformer in a PCB or in a stack of laminated PCBs reduces the effort for external interconnections to the transformer. Otherwise, the interconnections would need a significant volume of the coilformer and thus of the whole transformer. In fluorescent lamp applications, for example, a high ignition voltage of up to 2 kV may appear between the outputs. In such a case, integrating the interconnections in inner layers of the PCB allows a much denser routing, because the isolation distance is much smaller in inner layers of a PCB than on the surface and for interconnections to components on the top of the PCB. Since a plurality of planar secondary windings is to be arranged side by side, the number of required layers in a PCB or the number of required PCBs in a stack of PCBs comprising all transformer windings is limited, which contributes to cost efficiency.

A magnetic core of the transformer could be made for example from sintered ferrite material and attached to the winding afterwards. Alternatively, however, it could also be made of a material that can be laminated to a PCB. This way, the magnetic core can be buried in a stack of PCBs and additional PCB layers can be arranged on top of the transformer.

In an exemplary embodiment, the apparatus further comprises a driving circuit connected to a resonant circuit. The resonant circuit matches a predetermined output load of the transformer at a predetermined operating frequency. In this exemplary embodiment, at least a part of an inductivity of the resonant circuit could be given by a portion of the primary winding which is not covered by a plurality of secondary windings.

Such a resonant circuit can be used for ensuring that the transformer delivers a constant power output that is nearly independent of the load resistance. This may be useful if loads, which are connected to the power outputs of the transformer, have a resistance that may vary significantly during different stages of an operation.

In an exemplary embodiment, the apparatus further comprises a plurality of sensing windings. Each sensing winding is magnetically closely coupled to a respective secondary winding.

With the proposed transformer, the secondary windings can be nearly decoupled from each other. This means, a short circuit in a connected load reduces the output voltage only in the concerned secondary winding, but does not significantly reduce the induced voltage in neighboring secondary windings. Furthermore, in case a power matching circuit is used, an open output in a connected load leads to an increased induced voltage, but only in the concerned secondary winding. Therefore, the induced voltage und thus the magnetic flux through a particular secondary winding depends only on the state of the connected load. Introducing additional sensing windings that are closely magnetically coupled to the output windings thus allow an easy detection of the output state.

The actual detection of a fault can be realized by sensing circuits. In an exemplary embodiment, the apparatus comprises a plurality of such sensing circuits. Each sensing circuit is connected to at least one of the sensing windings. Further, each sensing circuit may be adapted to detect whether a voltage provided by the at least one sensing winding exceeds a first predetermined reference value, which indicates an open output. Alternatively or in addition, each sensing circuit may be adapted to detect whether a voltage provided by the at least one sensing winding falls short of a second predetermined reference value, which indicates a short circuit.

The sensing windings could be planar windings, which are arranged in a plane parallel to the secondary windings. With such an arrangement, a good coupling can be achieved between the secondary windings and the sensing windings. In an exemplary embodiment, the apparatus comprises in addition a plurality of loads, each load being connected to the output of another one of the planar secondary windings. In case the apparatus is a TV set, the loads could be given by the filaments of fluorescent lamps that are provided for a backlight of an LCD of the TV set. It is to be understood, however, that the transformer could be employed for various other applications as well.

These and other aspects of the invention will be apparent from and elucidated with reference to the embodiments described hereinafter.
Fig. 1 is a schematic block diagram of an apparatus according to an embodiment of the invention.
Fig. 2 is a simplified circuit diagram of an exemplary driving circuit of the apparatus of Figure 1.
Fig. 3 is a schematic diagram of a first exemplary winding layout for a transformer of the driving circuit of Fig. 2.
Fig. 4 is a schematic exploded view of a transformer with the winding layout of Fig. 3.
Fig. 5 is a diagram illustrating an output power of a resonant power converter as a function of the operating frequency with load resistance as a parameter.
Fig. 6 is a simplified circuit diagram of an exemplary sensing circuit of the apparatus of Figure 1.
Fig. 7 is a schematic exploded view of a transformer that is combined with sensing windings for the sensing circuit of Fig. 6.
Fig. 8 is a flow chart illustrating a method of producing a power converter of the apparatus of Fig. 1.
Fig. 9 is a schematic diagram of an alternative winding layout for the transformer of the driving circuit of Fig. 2.
Fig. 10 is a schematic diagram of a further alternative winding layout for the transformer of the driving circuit of Fig. 2.
Fig. 11 is a schematic diagram of a winding layout of a transformer according to the present invention to be implemented in the driving circuit of fig. 2.

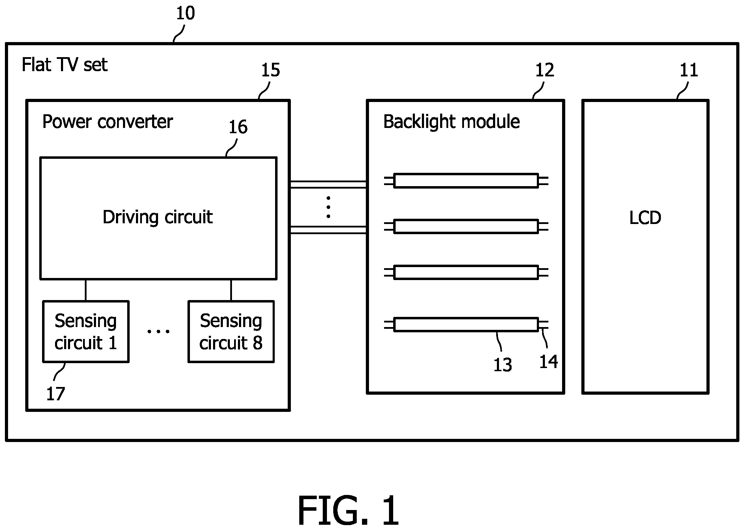

Fig. 1 is a schematic block diagram of an exemplary apparatus, in which a flat transformer according to an embodiment of the invention can be implemented.

The apparatus is a flat TV set 10. It comprises an LCD 11, a backlight module 12 and a power converter 15. It is to be understood that only components of the TV set 10, which are related to the present invention, are depicted.

The LCD 11 may be a conventional LCD and the backlight module 12 may be a conventional backlight module. The backlight module 12 comprises four fluorescent lamps 13 that are arranged in parallel to each other with equal distances in between two adjacent lamps 13. The four fluorescent lamps 13 provide a backlight for the LCD 11. Each lamp 13 comprises two filaments (not shown) and two terminals 14 for each filament. The backlight module 12 thus requires a total of sixteen connections. It is to be understood that any other number of fluorescent lamps could be used as well, for example the typical number of eight fluorescent lamps.

The power converter 15 comprises a driving circuit 16 and eight sensing circuits 17. The driving circuit 16 is provided for the filament heating of the fluorescent lamps 13. It includes a flat transformer according to an embodiment of the invention and a power matching resonant circuit. The sensing circuit 17 is provided for detecting a fault, namely an open output or a short circuit, in one of the lamps 13 of the backlight module 12. Driving circuit 16 and sensing circuits 17 will be described in more detail below.

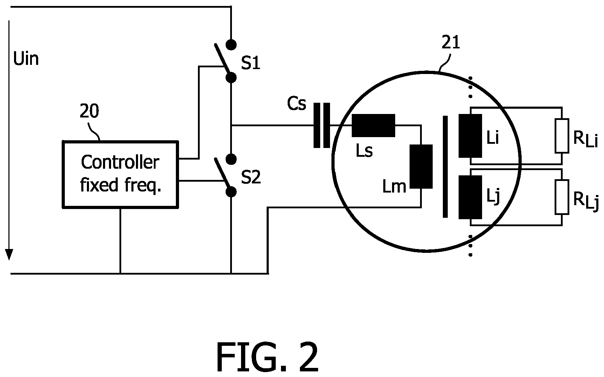

Fig. 2 is a simplified circuit diagram of an exemplary driving circuit 16.

The driving circuit 16 comprises a series connection of two switching components S1, S2, for instance two transistors. The series connection is arranged between a high potential and ground so that a direct voltage of Uin is applied to it. The junction between the switching components S1, S2 is connected via a capacitor Cs, a first inductance Ls and a second inductance Lm to ground. Capacitor Cs and inductance Ls form a resonant circuit. Inductance Lm is the effective part of the primary winding of an integrated transformer 21. The transformer 21 comprises in addition eight secondary windings. Two of these secondary windings are represented in Fig. 2 by inductors Li and Lj. The terminals of each secondary winding Li, Lj are connected to the terminals 14 of a respective filament of a fluorescence lamp 13 in the backlight module 12. Two of the filaments are represented in Fig. 2 by loads R_{Li} and R_{Lj2}.

A controller 20 switches the switching components S1, S2 alternately with a fixed frequency to provide a respective conductive connection. This results in alternating voltage across inductance Lm. The resulting magnetic flux induces an alternating voltage in inductors Li, Lj, which is applied to the respectively connected load R_{Li}, R_{Lj}.

It is to be understood that the driving circuit 16 could comprise various other components, like a rectifier rectifying an alternating line voltage to obtain the direct voltage Uin.

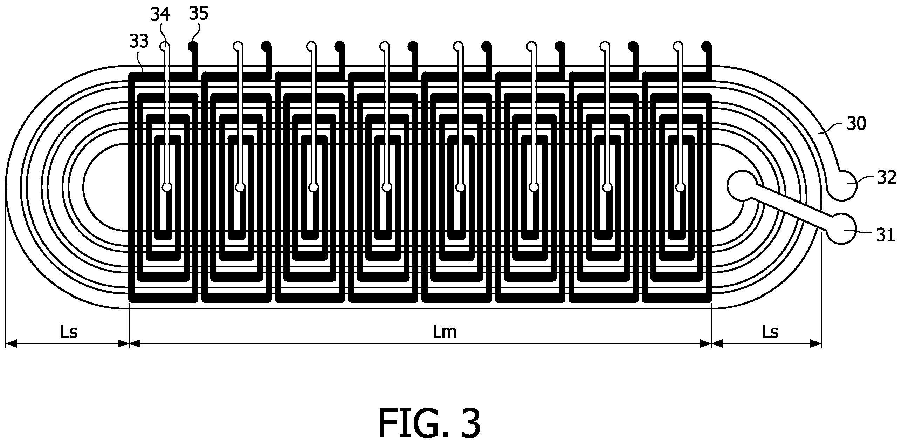

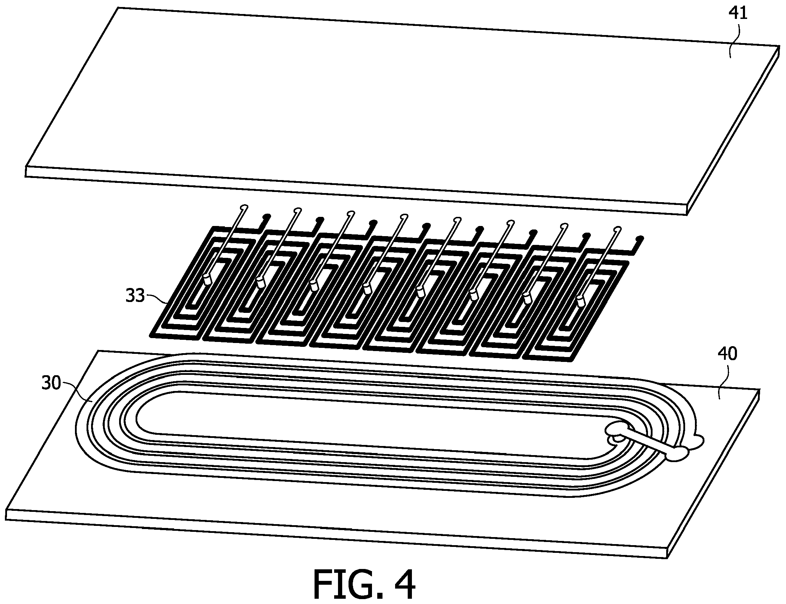

A structure of the integrated transformer 21 according to a first embodiment of the invention is illustrated in Fig. 3 and 4.

Fig. 3 is a schematic diagram of the winding layout of the transformer 21.

Inductances Ls and Lm of the driving circuit 16 are formed by a long, linear planar spiral winding 30, which is the primary winding of the transformer 21. The primary winding 30 has terminals 31 and 32, which are connected in the driving circuit 16 of Fig. 2 on the one hand to capacitor Cs and on the other hand to ground. The eight inductors Li, Lj are equally formed by planar spiral windings 33. These spiral windings 33 act as separate secondary windings of the transformer 21. Each secondary winding 33 has two terminals 34 and 35, which are connected in Fig. 2 to a respective load R_{Li}, R_{Lj}. The eight secondary windings 33 are all of the same size. They have approximately the same height as the primary winding 30, but a length of less than 1/8 of the primary winding 30. They are arranged side by side on top of the primary winding 30 such that a portion of the magnetic flux, which is caused when an alternating voltage is applied to the primary winding 30, penetrates each of the secondary windings 33.

Fig. 4 is a schematic exploded view of a transformer 21 having the winding layout of Fig. 3. The primary winding 30 is arranged on top of a first plate 40 of a softmagnetic core, the secondary windings 33 are arranged on top of the primary winding 30, and a second plate 41 of the softmagnetic core is arranged on top of the secondary windings 33.

It can be seen that when the four layers are arranged next to each other, a very flat transformer 21 is obtained.

The softmagnetic core is shown as plates 40, 41. It has to be noted, however, that the softmagnetic core could also be realized such that the top and the bottom half of the magnetic core are interconnected with softmagnetic material, for example by using planar E-cores or holes beside the windings filled with a ferrite polymer compound.

As mentioned above, capacitor Cs and inductance Ls belong to a resonant circuit. This resonant circuit is provided in order to ensure that the transformer 21 delivers a constant power output that is nearly independent of the load resistance.

This characteristic of a driving circuit 15 is of particular advantage when used for driving filaments of fluorescent lamps 13, because the resistance of the filaments may vary significantly between cold and hot filaments.

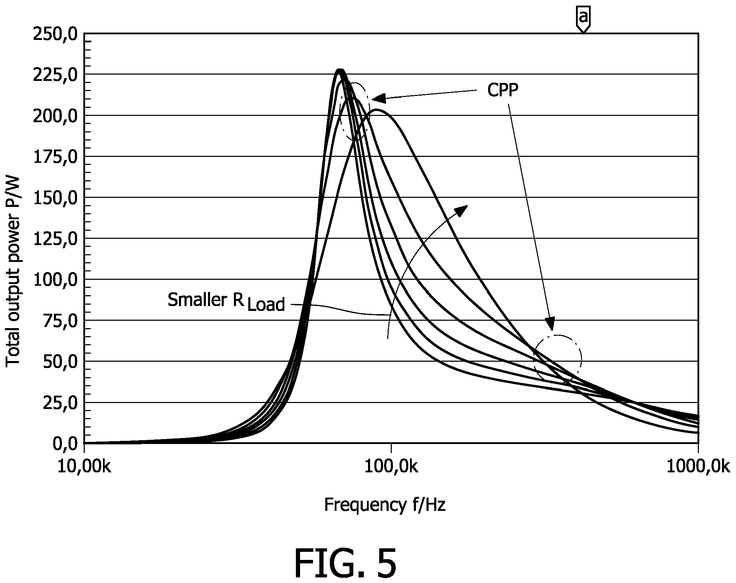

The series resonant circuit Cs, Ls is connected in series to the inductance Lm, which has a finite inductivity. Such a circuit exhibits a power transfer characteristic as shown in Figure 5. Figure 5 is a diagram presenting the total output power P in Watt W of the transformer 21 in dependence of the switching frequency f in Hz that is applied by the controller 20, with the total load resistance R_{Load} as a parameter. That is, a separate curve is presented for various load resistances.

There are two distinct frequencies, at which the output power depends only to a very limited extent on the total load resistance. These points are the "constant power points" CPP. One CPP is close to the basic resonant frequency of the resonant circuit Cs, Ls. It should be noted that it is not the respective resonant frequency itself, which exhibits the constant power characteristic, but a point close to it. Another CPP is located at higher switching frequencies. Here, the series impedance of Cs and Ls matches the typical output resistance, such that power matching appears. This operation point is typically more efficient and might therefore be preferred.

The driving circuit is thus advantageously designed such that the series connection of capacitor Cs and inductance Ls matches the total output load at the operation frequency. That is, the total impedance of capacitor Cs and inductance Ls is selected to be basically equal to the average total impedance of the load. If the output loads R_{Li}, R_{Lj} differ among each other in their resistance, they may be individually matched by adding capacitors in series or in parallel to the load R_{Li}, R_{Lj} on the secondary sides (not shown).

For implementing the series inductivity Ls, a certain part of the primary winding 30 may not be covered by the secondary windings 33, which leads to a leakage inductivity of the transformer 21. In the embodiment of Fig. 3 and 4, the round part at the two ends of the primary winding 30 act as this defined leakage inductivity and thus as a matching impedance.

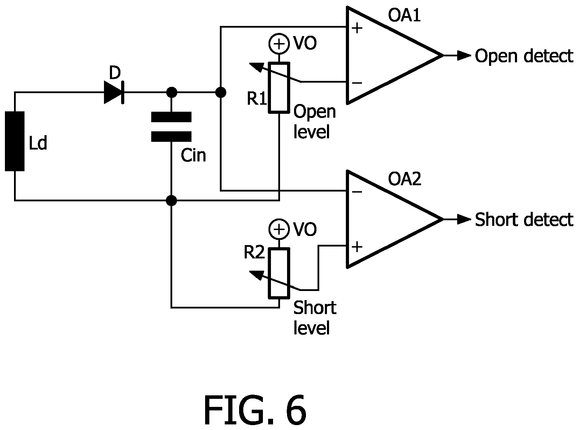

Fig. 6 is a simplified circuit diagram of an exemplary sensing circuit 17 for one of the secondary windings 33.

The sensing circuit 17 comprises a sensing winding, which is represented in Fig. 6 by an inductor Ld. One terminal of the inductor Ld is connected via a diode D and a capacitor Cin to ground. The other terminal of the inductor Ld is equally connected to ground. The sensing winding represented by inductor Ld is arranged to be closely magnetically coupled to one of the secondary windings 33 of the transformer 21, which are represented in Fig. 1 by inductors Li, Lj. Thus, the inductor Ld allows an easy detection of a faulty output state of a respective inductor Li, Lj, namely whether the connected filament R_{Li}, R_{Lj} causes a short circuit or an open output. The diode D functions as a rectifier for the voltage induced into the inductor Ld, and the capacitor Cin is used to obtain a DC voltage, which is proportional to the voltage induced into the inductor Ld.

For the actual detection of an open output, the junction between the diode D and the capacitor Cin is connected to a non-inverting input of a first operating amplifier OA1, which is employed as a first comparator. Moreover, a supply voltage V0 is connected via a first resistor R1 to ground. A variable tap on this resistor R1 is connected to an inverting input of the first comparator OA1. The voltage between the tap and ground is a first reference voltage that defines a predetermined upper limit for the voltage across the capacitor Cin. If the voltage across the capacitor Cin exceeds this upper limit, an open output is detected by the comparator OA1. This information may be used for example for notifying a user about an open output by activating an LED that is provided for indicating an open circuit of the monitored lamp 13.

For the actual detection of a short circuit, the junction between the diode D and the capacitor Cin is further connected to an inverting input of a second operating amplifier OA2, which is employed as a second comparator. The supply voltage V0 is connected in addition via a second resistor R2 to ground. A variable tap on this resistor R2 is connected to a non-inverting input of the second comparator OA2. The voltage between tap and ground is a second reference voltage that defines a predetermined lower limit for the voltage across the capacitor Cin. If the voltage across the capacitor Cin falls short of this lower limit, a short circuit is detected by the comparator OA2. This information may be used for example for notifying a user about a short circuit by activating an LED that is provided for indicating a short circuit in the monitored lamp 13.

In the embodiment of Fig. 1, eight sensor circuits 17 are provided, one for each of the secondary windings 33 of the transformer 21 of the driving circuit 16. To reduce the required number of components and to simplify the manufacturing process, however, it is also possible to monitor a plurality of secondary windings 33 in common. In particular, two secondary windings 33 that are connected to the filaments of a single lamp 13 could be monitored in common. In this case, the inductor Ld in Fig. 6 may represent two sensing windings that are connected in series such that only one sensing circuit 17 per lamp 13 is needed.

A good coupling between a sensing winding and a respective secondary winding 33 can be achieved by placing planar sensing spiral windings on top of the secondary windings.

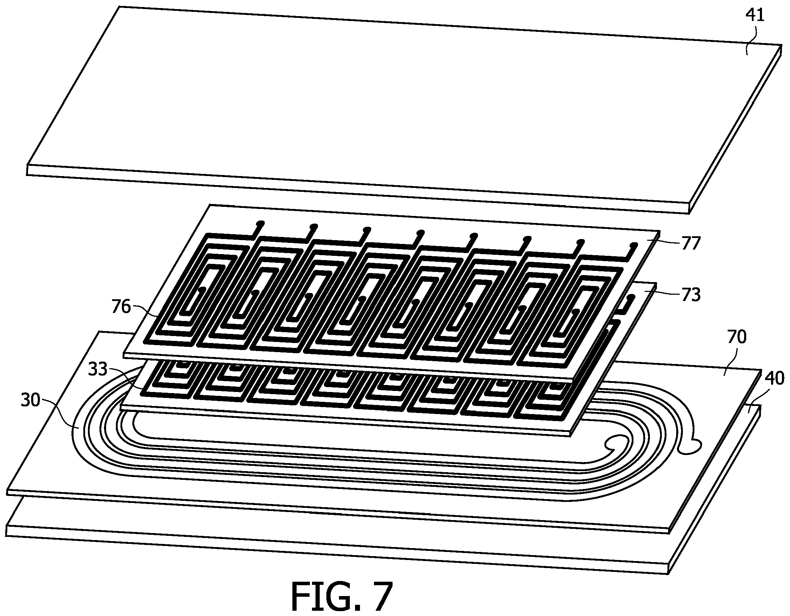

Fig. 7 shows an example of such an arrangement, which proceeds from the arrangement of Fig. 4 and includes in addition the sensing windings and PCBs in which the respective windings are integrated. The same reference numerals are used for the same components as in Fig. 4. The arrangement comprises a stack of parallel layers, including in this order a lower part 40 of a softmagnetic core, a primary winding 30 on a first PCB 70, secondary windings 33 on a second PCB 73, sensing windings 76 on a third PCB 77 and an upper part 41 of a softmagnetic core. The sensing windings 76 are arranged side by side in the same manner as the secondary windings 33 such that a respective sensing winding 76 comes to lie exactly on top of one of the secondary windings 33 in the stack.

Compared to the arrangement of Fig. 4, the arrangement of Fig. 7 requires only one additional PCB layer 77 that contributes only little to the total size of the transformer 21. Since the sensing windings 76 are electrically isolated from the secondary windings 33, they can be connected to a sensing circuit 17 on the primary side.

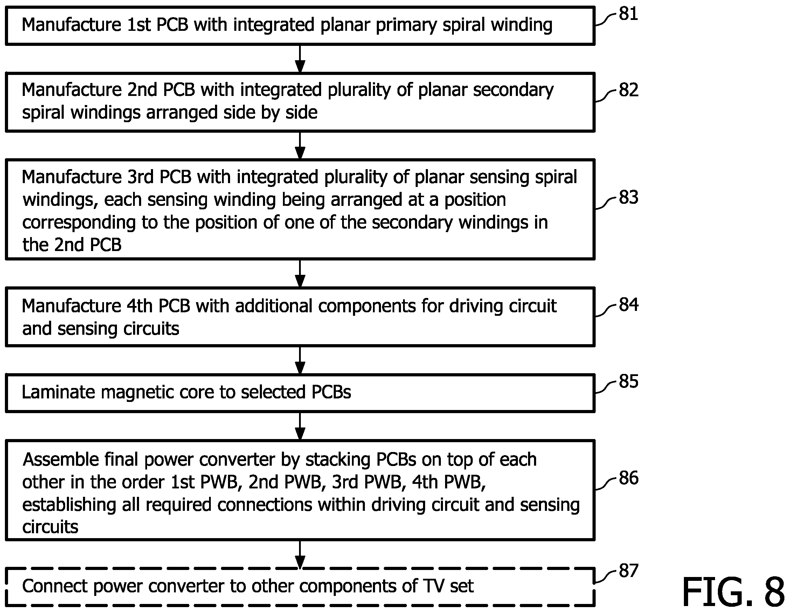

Finally, a method of producing a power converter 15 including the transformer 21 of Fig. 7 will be described with reference to the flow chart of Fig. 8.

In step 81, a first PCB 70 with an integrated planar primary spiral winding 30 and the required connections is manufactured. The primary winding is a long, linear winding, as indicated for instance in Fig. 7.

In step 82, a second PCB 73 with an integrated plurality of planar secondary spiral windings 33 and the required connections is manufactured. The secondary windings 33 are arranged side by side, as indicated for instance in Fig. 7.

In step 83, a third PCB 77 with an integrated plurality of planar sensing spiral windings 76 and the required connections is manufactured. The number of sensing windings 76 corresponds to the number of the secondary windings 33, and the sensing windings 76 are arranged at the same positions in the PCB 77 as the secondary windings 33 are arranged in PCB 73.

In step 84, a fourth PCB with all remaining components of the driving circuit 16 and of eight sensing circuits 17 and the required connections is manufactured.

The substrate employed for one or more of the PCBs can also be flexible; it could be made for instance from Polyimide, like Flexfoil™.

In step 85, a magnetic core 40, 41 is laminated to the lower surface of the first PCB 70 and to the lower surface of the fourth PCB. Alternatively, the magnetic core 40, 41 could be laminated to the lower surface of the first PCB 70 and to the upper surface of the third PCB 77. Laminating a magnetic core onto PCBs can be realized for example with a magnetic core that is made of a ferrite polymer compound or with a flexible softmagnetic metal foil like Mumetal^{®}. By laminating the magnetic core 40, 41 onto PCBs, it can be buried in the PCB layers. This allows arranging additional PCB layers on top of the PCBs 70, 73, 77 that are used for the transformer 21.

In step 86, the first, second, third and fourth PCB are then stacked in this order and laminated closely together, to obtain the power converter 15. With the stacking, all required connections of the driving circuit 16 and the sensing circuit 17 are established.

In step 87, finally, the power converter 15 may be connected to other components of the TV set 10, for instance to a power supply (not shown) and to the backlight module 12. Since this step does not belong to the actual production of the power converter 15, it is indicated in Fig. 8 with dashed lines.

It has to be noted that the order of the indicated steps can be varied in many ways. The four PCBs can be manufactured for example in any order. Further, the four PCBs could also be manufactured at first side by side on a single substrate, which is then separated into four parts. Thus, steps 81 to 84 could also be realized in a single step or as interleaved steps. Moreover, the magnetic core 40, 41 could also be laminated onto the lower surface of the substrate for a respective PCB (step 85) before the components are added (steps 81 or 84).

On the whole, it becomes apparent that the exemplary embodiment of the invention presented with reference to Fig. 1, 2, 5, 6 and 8 enables the production and use of a flat transformer, which facilitates in addition power matching and fault detection.

It is to be understood that the arrangement of primary and secondary windings 30, 33 as shown in Fig. 3, 4 and 7 could be varied in many ways, some of which will be presented in the following.

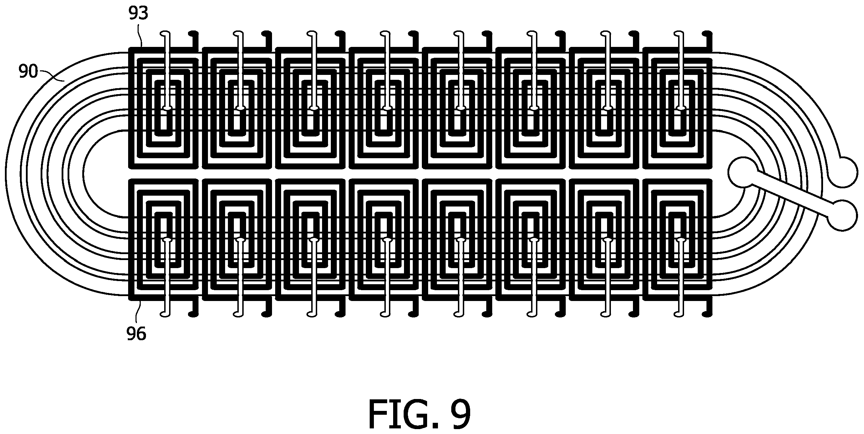

In a first alternative not being part of the invention as claimed, presented in Fig. 9, the primary winding is again a long, linear planar spiral winding 90. In this case, however, sixteen planar secondary spiral windings 93, 96 are provided. The sixteen secondary windings 93, 96 have approximately half of the height of the primary spiral winding 90, and a length of less than 1/8 of the primary spiral winding 90. Eight of the secondary windings 93 are arranged side by side in a first row on top one of the long sides of the primary winding 90, while the remaining eight secondary windings 96 are arranged side by side in a second row on top of the other long side of the primary winding 90 such that a portion of the magnetic flux, which is caused when an alternating voltage is applied to the primary winding 90, penetrates each secondary winding 93, 96.

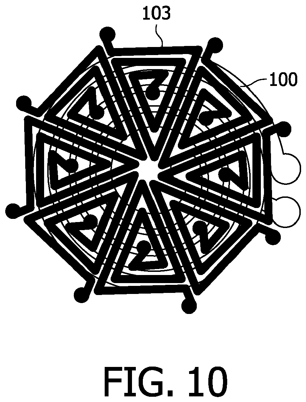

In a second alternative not being part of the invention as claimed, presented in Fig. 10, the primary winding is a circular planar spiral winding 100. Eight secondary windings 103 may then be formed as triangular planar spiral windings. These triangular secondary windings 103 are arranged side by side in form of a circle such that each triangular secondary winding 103 is arranged on top of another sector of the circle formed by the primary winding 100.

A third alternative not being part of the invention as claimed, proceeds from the arrangement in Fig. 3. In this case, however, a second row of eight planar secondary spiral windings is arranged exactly on top of the presented first row of eight planar secondary spiral windings. It would be possible, for example, to stack respectively two secondary spiral windings on top of each other that provide the outputs that are associated to one lamp 13.

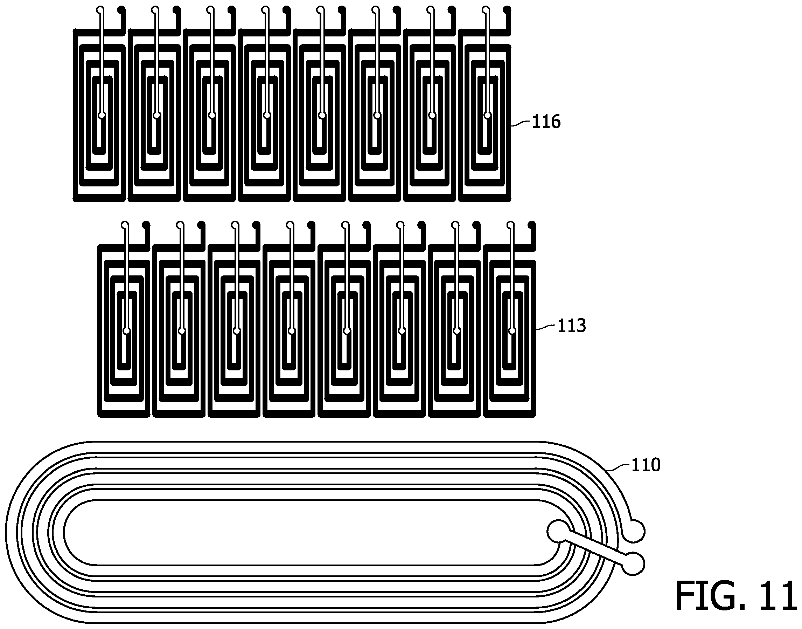

The embodiment presented in Fig. 11 is a variation of the third alternative. Fig. 11 shows the layers that are used in this alternative separately; it is not a top view on combined layers as Fig. 3, 9 and 10. The primary winding 110 is again a long, linear planar spiral winding 110. Further, sixteen planar secondary spiral windings 113, 116 are provided. The sixteen secondary windings 113, 116 have approximately the same height as the primary spiral winding 110, and a length of less than 1/8 of the primary spiral winding 110. Eight of the secondary windings 113 are arranged side by side in a first layer on top of the primary winding 110, slightly shifted to the right of the center of the primary winding 110. Further eight of the secondary windings 116 are arranged side by side in a second layer on top of the secondary windings 113, slightly shifted to the left of the center of the primary winding 110. The second layer of secondary windings 116 is shifted more specifically such that the center of each secondary winding 116, except for the leftmost secondary winding 116, comes to lie in the middle between respectively two secondary windings 113. With this construction, the magnetic flux produced by the primary winding 110 can be exploited more efficiently than with two layers of secondary windings that are arranged exactly on top of each other as in the presented third alternative. Further, the space between the secondary windings can be used in this case to route a track that connects the inner end of a winding on the respective other layer to an outside connector.

While the invention has been illustrated and described in detail in the drawings and foregoing description, such illustration and description are to be considered illustrative or exemplary and not restrictive; the invention is not limited to the disclosed embodiments. Variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. Transformer (21) comprising a planar primary winding (30;90;100;110) and a first plurality of planar secondary windings (33;93;103;113) and a second plurality of planar secondary windings (116), wherein each secondary winding (33;93;103;113;116) provides an isolated output (34,35), said first plurality of planar secondary windings (33;93;103;113) being arranged side by side in a plane parallel to said primary winding (30;90;100;110) such that a portion of a magnetic flux generated by said primary winding (30;90;100;110) penetrates each of said first plurality of planar secondary windings (33;93;103;113), said second plurality of planar secondary windings (116) being arranged side by side in a plane parallel to said primary winding (110) and to said first plurality of planar secondary windings (113) such that a portion of a magnetic flux generated by said primary winding (110) penetrates each of said second plurality of planar secondary windings (116), wherein the first and the second plurality of secondary windings are shifted against each other, such that the magnetic flux in the area between the secondary windings of the first layer can be used by the secondary windings in the second layer.

2. Transformer (21) according to claim 1, wherein at least one of said primary winding (30) and said first plurality of secondary windings (33) is integrated in a substrate.

3. Transformer (21) according to claim 1, wherein at least one of said primary winding (30) and said first plurality of secondary windings (33) is laminated in at least one printed circuit board (70,73).

4. Transformer (21) according to claim 3, further comprising a magnetic core (40,41), which is laminated to at least one printed circuit board (70).

5. Apparatus (10; 15) comprising a transformer (21) according to claim 1.

6. Apparatus (15) according to claim 5, further comprising a driving circuit (16) connected to a resonant circuit for matching a predetermined output load of said transformer (21) at a predetermined operating frequency.

7. Apparatus (15) according to claim 6, wherein at least a part of an inductivity of said resonant circuit is given by a portion of said primary winding (30) which is not covered by said first plurality of secondary windings (33).

8. Apparatus (15) according to claim 5, further comprising a plurality of sensing windings (76), each sensing winding (76) being magnetically closely coupled to a respective secondary winding (33).

9. Apparatus (15) according to claim 8, wherein said sensing windings (76) are planar windings, which are arranged in a plane parallel to said first plurality of secondary windings (33).

10. Apparatus (15) according to claim 8, further comprising a plurality of sensing circuits (17), each sensing circuit (17) being connected to at least one of said sensing windings (76) and each sensing circuit (17) being adapted to detect at least one of whether a voltage provided by said at least one sensing winding (76) exceeds a first predetermined reference voltage and whether a voltage provided by said at least one sensing winding (76) falls short of a second predetermined reference voltage.

11. Apparatus (10) according to claim 5, further comprising a respective load (R_{Li}, R_{Lj}) connected to the output (34,35) of each of said secondary windings (33).

12. Method of producing a transformer (21), said method comprising
- manufacturing a planar primary winding (30,110),
- manufacturing a first plurality of planar secondary windings (33,113) and manufacturing a second plurality of planar secondary windings (116), wherein each secondary winding (33,113,116) provides an isolated output (34,35), said first plurality of secondary windings (33,113) being arranged side by side, and said second plurality of secondary windings (116) being arranged side by side,
- arranging said first plurality of secondary windings (33,113) in a plane parallel to said primary winding (30,110) such that a portion of a magnetic flux generated by said primary winding (30,110) penetrates each of said first plurality of secondary windings (33,113) and arranging said second plurality of secondary windings (116) in a plane parallel to said primary winding (30,110) and to said first plurality of planar secondary windings (33,113) such that a portion of a magnetic flux generated by said primary winding (30,110) penetrates each of said second plurality of secondary windings (116), and
- arranging said second plurality of planar secondary windings (116) such that it is shifted compared to said first plurality of planar secondary windings (33,11 3), and such that the magnetic flux in the area between the secondary windings of the first layer can be used by the secondary windings in the second layer.

## Patentansprüche

1. Transformator (21) mit einer planaren Primärwicklung (30;90;100;110) und einer ersten Mehrzahl von planaren Sekundärwicklungen (33;93;103;113) sowie einer zweiten Mehrzahl von planaren Sekundärwicklungen (116), wobei jede Sekundärwicklung (33;93;103;113;116) einen isolierten Ausgang (34,35) vorsieht, wobei die erste Mehrzahl von planaren Sekundärwicklungen (33;93;103;113) nebeneinander in einer Ebene parallel zu der Primärwicklung (30;90;100;110) so angeordnet ist, dass ein Teil eines von der Primärwicklung (30;90;100;110) erzeugten Magnetflusses jede der ersten Mehrzahl von planaren Sekundärwicklungen (33;93;103;113) durchdringt, wobei die zweite Mehrzahl von planaren Sekundärwicklungen (116) nebeneinander in einer Ebene parallel zu der Primärwicklung (110) und zu der ersten Mehrzahl von planaren Sekundärwicklungen (113) so angeordnet ist, dass ein Teil eines von der Primärwicklung (110) erzeugten Magnetflusses jede der zweiten Mehrzahl von planaren Sekundärwicklungen (116) durchdringt, wobei die erste und die zweite Mehrzahl von Sekundärwicklungen gegeneinander verschoben sind, so dass der Magnetfluss in dem Bereich zwischen den Sekundärwicklungen der ersten Schicht von den Sekundärwicklungen in der zweiten Schicht verwendet werden kann.

2. Transformator (21) nach Anspruch 1, wobei zumindest die Primärwicklung (30) oder die erste Mehrzahl von Sekundärwicklungen (33) in ein Substrat integriert ist.

3. Transformator (21) nach Anspruch 1, wobei zumindest die Primärwicklung (30) oder die erste Mehrzahl von Sekundärwicklungen (33) in mindestens eine Leiterplatte (70,73) laminiert ist.

4. Transformator (21) nach Anspruch 3, weiterhin umfassend einen Magnetkern (40,41), der auf mindestens eine Leiterplatte (70) laminiert ist.

5. Vorrichtung (10;15) mit einem Transformator (21) nach Anspruch 1.

6. Vorrichtung (15) nach Anspruch 5, weiterhin umfassend eine mit einem Resonanzkreis verbundene Ansteuerungsschaltung (16) zur Anpassung einer vorher festgelegten Ausgangslast des Transformators (21) an eine vorher festgelegte Betriebsfrequenz.

7. Vorrichtung (15) nach Anspruch 6, wobei zumindest ein Teil einer Induktivität des Resonanzkreises durch einen Teil der Primärwicklung (30) gegeben ist, der nicht von der ersten Mehrzahl von Sekundärwicklungen (33) bedeckt ist.

8. Vorrichtung (15) nach Anspruch 5, weiterhin umfassend eine Mehrzahl von Messwicklungen (76), wobei jede Messwicklung (76) mit einer jeweiligen Sekundärwicklung (33) magnetisch eng gekoppelt ist.

9. Vorrichtung (15) nach Anspruch 8, wobei die Messwicklungen (76) planare Wicklungen sind, die in einer Ebene parallel zu der ersten Mehrzahl von Sekundärwicklungen (33) angeordnet sind.

10. Vorrichtung (15) nach Anspruch 8, weiterhin umfassend eine Mehrzahl von Messschaltungen (17), wobei jede Messschaltung (17) mit mindestens einer der Messwicklungen (76) verbunden ist und jede Messschaltung (17) so eingerichtet ist, dass sie zumindest detektiert, ob eine von der mindestens einen Messwicklung (76) vorgesehene Spannung eine erste vorher festgelegte Referenzspannung überschreitet oder ob eine von der mindestens einen Messwicklung (76) vorgesehene Spannung eine zweite vorher festgelegte Referenzspannung unterschreitet.

11. Vorrichtung (10) nach Anspruch 5, weiterhin umfassend eine jeweilige Last (R_{Li}, R_{Lj}), die mit dem Ausgang (34,35) von jeder der Sekundärwicklungen (33) verbunden ist.

12. Verfahren zur Herstellung eines Transformators (21), wobei das Verfahren die folgenden Schritte umfasst, wonach:
- eine planare Primärwicklung (30,110) hergestellt wird,
- eine erste Mehrzahl von planaren Sekundärwicklungen (33,113) hergestellt wird und eine zweite Mehrzahl von planaren Sekundärwicklungen (116) hergestellt wird, wobei jede Sekundärwicklung (33,113,116) einen isolierten Ausgang (34,35) vorsieht, wobei die erste Mehrzahl von Sekundärwicklungen (33,113) nebeneinander angeordnet wird und die zweite Mehrzahl von Sekundärwicklungen (116) nebeneinander angeordnet wird,
- die erste Mehrzahl von Sekundärwicklungen (33,113) in einer Ebene parallel zu der Primärwicklung (30,110) so angeordnet wird, dass ein Teil eines von der Primärwicklung (30,110) erzeugten Magnetflusses jede der ersten Mehrzahl von Sekundärwicklungen (33,113) durchdringt, und die zweite Mehrzahl von Sekundärwicklungen (116) in einer Ebene parallel zu der Primärwicklung (30,110) und zu der ersten Mehrzahl von planaren Sekundärwicklungen (33,113) so angeordnet wird, dass ein Teil eines von der Primärwicklung (30,110) erzeugten Magnetflusses jede der zweiten Mehrzahl von Sekundärwicklungen (116) durchdringt, und
- die zweite Mehrzahl von planaren Sekundärwicklungen (116) so angeordnet wird, dass sie zu der ersten Mehrzahl von planaren Sekundärwicklungen (33,113) verschoben ist, und dass der Magnetfluss in dem Bereich zwischen den Sekundärwicklungen der ersten Schicht von den Sekundärwicklungen in der zweiten Schicht verwendet werden kann.

## Revendications

1. Transformateur (21) comprenant un enroulement primaire plan (30 ; 90 ; 100 ; 110) et une première pluralité d'enroulements secondaires plans (33 ; 93 ; 103 ; 113) et une seconde pluralité d'enroulements secondaires plans (116), dans lequel chaque enroulement secondaire (33 ; 93 ; 103 ; 113 ; 116) fournit une sortie isolée (34, 35), ladite première pluralité d'enroulements secondaires plans (33 ; 93 ; 103 ; 113) étant agencés côte à côte dans un plan parallèle audit enroulement primaire (30 ; 90 ; 100 ; 110) de telle sorte qu'une portion d'un flux magnétique généré par ledit enroulement primaire (30 ; 90 ; 100 ; 110) pénètre dans chacun parmi ladite première pluralité d'enroulements secondaires plans (33 ; 93 ; 103 ; 113), ladite seconde pluralité d'enroulements secondaires plans (116) étant agencés côte à côte dans un plan parallèle audit enroulement primaire (110) et à ladite première pluralité d'enroulements secondaires plans (113) de telle sorte qu'une portion d'un flux magnétique généré par ledit enroulement primaire (110) pénètre dans chacun parmi ladite seconde pluralité d'enroulements secondaires plans (116), dans lequel les première et seconde pluralités d'enroulements secondaires sont déplacées l'une contre l'autre, de telle sorte que le flux magnétique dans la zone entre les enroulements secondaires de la première couche puisse être utilisé par les enroulements secondaires dans la seconde couche.

2. Transformateur (21) selon la revendication 1, dans lequel au moins l'un parmi ledit enroulement primaire (30) et ladite première pluralité d'enroulements secondaires (33) est intégré dans un substrat.

3. Transformateur (21) selon la revendication 1, dans lequel au moins l'un parmi ledit enroulement primaire (30) et ladite première pluralité d'enroulements secondaires (33) est stratifié dans au moins une carte de circuit imprimé (70,73).

4. Transformateur (21) selon la revendication 3, comprenant en outre un noyau magnétique (40, 41), qui est stratifié sur au moins une carte de circuit imprimé (70).

5. Appareil (10 ; 15) comprenant un transformateur (21) selon la revendication 1.

6. Appareil (15) selon la revendication 5, comprenant en outre un circuit d'excitation (16) connecté à un circuit résonant pour correspondre à une charge de sortie prédéterminée dudit transformateur (21) à une fréquence de fonctionnement prédéterminée.

7. Appareil (15) selon la revendication 6, dans lequel au moins une partie d'une inductivité dudit circuit résonant est fournie par une portion dudit enroulement primaire (30) qui n'est pas couverte par ladite première pluralité d'enroulements secondaires (33).

8. Appareil (15) selon la revendication 5, comprenant en outre une pluralité d'enroulements de détection (76), chaque enroulement de détection (76) étant magnétiquement couplé à un enroulement secondaire respectif (33).

9. Appareil (15) selon la revendication 8, dans lequel lesdits enroulements de détection (76) sont des enroulements plans, qui sont agencés dans un plan parallèle à ladite première pluralité d'enroulements secondaires (33).

10. Appareil (15) selon la revendication 8, comprenant en outre une pluralité de circuits de détection (17), chaque circuit de détection (17) étant connecté à au moins l'un desdits enroulements de détection (76) et chaque circuit de détection (17) étant adapté pour détecter au moins l'un parmi le fait qu'une tension fournie par ledit au moins un enroulement de détection (76) excède ou non une première tension de référence prédéterminée et le fait qu'une tension fournie par ledit au moins un enroulement de détection (76) est en deçà ou non d'une seconde tension de référence prédéterminée.

11. Appareil (10) selon la revendication 5, comprenant en outre une charge respective (R_{Li}, R_{Lj}) connectée à la sortie (34, 35) de chacun parmi lesdits enroulements secondaires (33).

12. Procédé de production d'un transformateur (21), ledit procédé comprenant
- la fabrication d'un enroulement primaire plan (30, 110),
- la fabrication d'une première pluralité d'enroulements secondaires plans (33, 113) et la fabrication d'une seconde pluralité d'enroulements secondaires plans (116), dans lequel chaque enroulement secondaire (33, 113, 116) fournit une sortie isolée (34, 35), ladite première pluralité d'enroulements secondaires (33, 113) étant agencés côte à côte, et ladite seconde pluralité d'enroulements secondaires (116) étant agencés côte à côte,
- l'agencement de ladite première pluralité d'enroulements secondaires (33, 113) dans un plan parallèle audit enroulement primaire (30, 110) de telle sorte qu'une portion d'un flux magnétique généré par ledit enroulement primaire (30, 110) pénètre dans chacun parmi ladite première pluralité d'enroulements secondaires (33, 113) et l'agencement de ladite seconde pluralité d'enroulements secondaires (116) dans un plan parallèle audit enroulement primaire (30, 110) et à ladite première pluralité d'enroulements secondaires plans (33, 113) de telle sorte qu'une portion d'un flux magnétique généré par ledit enroulement primaire (30, 110) pénètre dans chacun parmi ladite seconde pluralité d'enroulements secondaires (116), et
- l'agencement de ladite seconde pluralité d'enroulements secondaires plans (116) de telle sorte qu'elle soit déplacée par rapport à ladite première pluralité d'enroulements secondaires plans (33, 113), et de telle sorte que le flux magnétique dans la zone entre les enroulements secondaires de la première couche puisse être utilisé par les enroulements secondaires dans la seconde couche.
